**Europäisches Patentamt**

**European Patent Office**

**Office européen des brevets**

(19)

(11) Veröffentlichungsnummer: **0 149 277**
**B1**

(12) **EUROPÄISCHE PATENTSCHRIFT**

(45) Veröffentlichungstag der Patentschrift:
31.05.89

(51) Int. Cl.⁴: **H 03 K 4/50**

(21) Anmeldenummer: **84201866.5**

(22) Anmeldetag: **14.12.84**

(54) **Monolithisch integrierter RC-Oszillator.**

(30) Priorität: **19.12.83 DE 3345852**

(43) Veröffentlichungstag der Anmeldung:
**24.07.85 Patentblatt 85/30**

(45) Bekanntmachung des Hinweises auf die Patenterteilung:
**31.05.89 Patentblatt 89/22**

(84) Benannte Vertragsstaaten:
**DE FR GB IT**

(56) Entgegenhaltungen:
**DE-B-1 512 353**
**DE-B-1 921 035**
**US-A-4 115 748**

**IEEE JOURNAL OF SOLID-STATE CIRCUITS, Band SC-13, Nr. 6, 1978; H.R. CAMENZIND et al. "A low voltage IC timer", Seiten 847-852**

(73) Patentinhaber: **Philips Patentverwaltung GmbH, Wendenstrasse 35 Postfach 10 51 49, D-2000 Hamburg 1 (DE)**

(84) Benannte Vertragsstaaten: **DE**

(73) Patentinhaber: **N.V. Philips' Gloeilampenfabrieken, Groenewoudseweg 1, NL- 5621 BA Eindhoven (NL)**

(84) Benannte Vertragsstaaten: **FR GB IT**

(72) Erfinder: **Kohsiek, Cord Heinrich, Hamburger Weg 10, D-2086 Ellerau (DE)**

(74) Vertreter: **David, Günther M., Philips Patentverwaltung GmbH Wendenstrasse 35 Postfach 10 51 49, D-2000 Hamburg 1 (DE)**

EP 0 149 277 B1

## Beschreibung

Die Erfindung betrifft einen monolithisch integrierten RC-Oszillator mit einem externen Anschluß zum Anschliessen eines zwischen diesem Anschluß und Bezugspotential liegendem externen Netzwerk aus Kapazität und Entladeschaltung, bei der mit dem Netzwerk eine periodisch ein- und ausschaltbare Ladeschaltung verbunden ist, und der eine Anschluß mit einer zwei Schaltschwellen aufweisenden Schwellwertschaltung verbunden ist, welche die Ladeschaltung ein- bzw. ausschaltet, wenn die Spannung an der Kapazität des Netzwerkes die untere, bzw. die obere Ansprechschwelle erreicht.

Ein Oszillator dieser Art ist aus der DE-OS-1 921 035 bekannt. Oszillatoren dieser Art werden in Form einer integrierten Schaltung häufig zur Erzeugung einer Sägezahnspannung verwendet. Da die externen frequenzbestimmenden Glieder nur mit einem Anschluß der integrierten Schaltung verbunden zu werden brauchen, werden Oszillatoren dieser Art auch als "1-Pin-Oszillator" bezeichnet. Bei einem solchen Oszillator ist die externe Entladeschaltung in der Regel ein der Kapazität parallel geschalteter Widerstand. Die eine Flanke des von einem solchen Oszillator erzeugten Sägezahns (während der Zeit $T_2$) wird durch den externen Widerstand und die externe Kapazität bestimmt, die andere Flanke (während der Zeit $T_1$) ebenfalls durch diese beiden Größen und einen in der integrierten Schaltung erzeugten Ladestrom. Um nun den Einfluß der unvermeidlichen Streuung des Ladestroms auf die Oszillatorfrequenz klein zu halten, wird $T_2$ sehr viel größer als $T_1$ gewählt.

Daraus ergibt sich der Nachteil, daß während der Zeit $T_1$ ein hoher Ladestrom fließt, was zu verschiedenen Problemen (Impulsbelastung der Stromversorgung, hohe Strombelastung der Bauelemente, Rundfunkstörungen) führen kann.

Aus der DE-B-1 512 353 ist ein symmetrischer Dreieckspannungsgenerator bekannt, bei dem ein erster (frequenzbestimmender) Kondensator aus einer Speisequelle über einen ersten Schalter aufgeladen wird, wobei ein Multivibrator, wenn eine bestimmte Spannung am ersten Kondensator erreicht wird, umschaltet und den ersten Schalter öffnet und einen zweiten Schalter schließt. Der erste Kondensator wird darauf entladen, bis ein Pegel erreicht wird, bei dem der Multivibrator wieder in den vorhergehenden Zustand gelangt, und der erste Schalter sich schließt und der zweite Schalter sich öffnet. Um eine möglichst symmetrische Dreieckspannung zu erhalten, wird bei diesem Generator der Ladestrom von der Spannung über einem zweiten Kondensator gesteuert, der während des Ladens bzw. des Entladens des ersten Kondensators entladen bzw. geladen wird, wobei die Lade- bzw. Entladeströme für beide Kondensatoren gleich sind und aus denselben Stromquellen stammen.

Der Erfindung liegt die Aufgabe zugrunde, einen Oszillator der eingangs genannten Art so auszubilden, daß das Verhältnis zwischen Vorder- und Rückflanke des erzeugten Sägezahnes frei gewählt werden kann, wobei die Zeit $T_1$ (erste Flanke des Sägezahns) nicht mehr von einem mit Streuungen behafteten, fest eingestellten Aufladestrom und dessen Temperaturkoeffizient abhängig ist.

Diese Aufgabe wird erfindungsgemäß dadurch gelöst, daß bei einem Oszillator der eingangs genannten Art der Ladestrom der Ladeschaltung von der Spannung über einer zweiten Kapazität gesteuert wird, die während des Entladens der frequenzbestimmenden Kapazität mit einem einstellbaren Strom $I_1$ auf- bzw. entladen und während des Aufladens der Kapazität mit einem ebenfalls einstellbaren Strom $I_2$ ent- bzw. aufgeladen wird.

Dies hat den Vorteil, daß die Zeit $T_1$ nur noch von der Zeit $T_2$ und nicht mehr von der Dimensionierung der Stromquelle abhängt. Die Bedingung, daß $T_2$ sehr viel größer ist als $T_1$, braucht also nicht mehr erfüllt werden. Es entfallen damit die schon genannten Nachteile (Impulsbelastung der Stromversorgung, hohe Strombelastung der Bauelemente etc).

Die erzielbare Frequenzgenauigkeit ist höher.

Weitere Ausgestaltungen der Erfindung ergeben sich aus den Unteransprüchen.

Ein Ausführungsbeispiel der Erfindung wird im folgenden anhand der beigefügten Zeichnung näher erläutert.

Es zeigen:

Fig. 1  Das Prinzipschaltbild eines monolithisch integrierten RC-Oszillators nach der Erfindung.

Fig. 2a  bis c den zeitlichen Verlauf von Spannungen und Strömen in dem Oszillator nach Fig. 1.

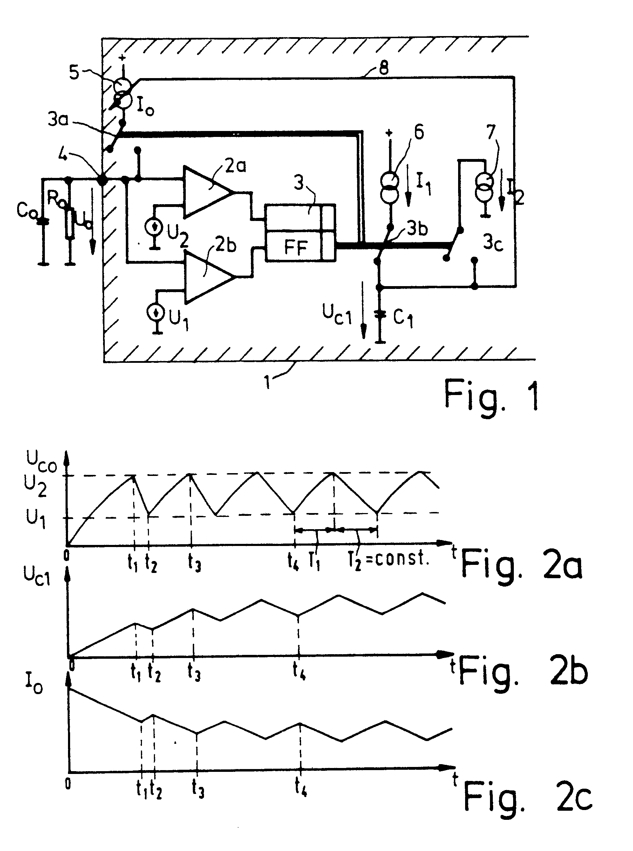

Die Figur 1 zeigt in schematischer Darstellung das Schaltbild eines monolithisch integrierten RC-Oszillators nach der Erfindung. Alle hier interessierenden Schaltungselemente dieser Schaltung die integriert sind, sind innerhalb der die Chip-Grenzen andeutenden Umrandung 1 gezeichnet. Lediglich das frequenzbestimmende Netzwerk, das hier aus der Parallelschaltung einer Kapazität $C_0$ mit einem Widerstand $R_0$ besteht, liegt außerhalb der integrierten Schaltung zwischen Bezugspotential (im vorliegenden Falle Masse) und einem Eingang 4 der integrierten Schaltung. Mit diesem einen Eingang 4 ist innerhalb der integrierten Schaltung eine Ladeschaltung verbunden, die aus einer Stromquelle 5 besteht, die über einen Schalter 3a periodisch angeschaltet werden kann. Weiter ist mit diesem einen Eingang 4 eine Schwellwertschaltung verbunden, die aus zwei Komparatoren 2a und 2b besteht, die einen Flip-Flop 3 ansteuern. Die Schaltschwellen der Schwellwertschaltung 2a, 2b, 3 werden durch die beiden den Komparatoren zugeführten Spannungen $U_1$ und $U_2$ bestimmt. Das Flip-Flop 3 schaltet über den hier nur symbolisch dargestellten Schalter 3a den Ladestrom $I_0$ aus der Stromquelle 5 an und aus.

Die soweit beschriebene Schaltung arbeitet wie folgt. Die externe Kapazität $C_0$, der der Widerstand $R_0$ parallel geschaltet ist, wird durch die Stromquelle 5 geladen, bis die Spannung $U_0$ über der externen Kapazität den Wert $U_2$ erreicht hat. Der Komparator 2a löscht dann das Flip-Flop 3, welches dann über den Schalter 3a den Strom $I_0$ abschaltet.

Die Kapazität $C_0$ entlädt sich dann über den parallel geschalteten Widerstand $R_0$, bis die Spannung $U_0$ über der Kapazität den Wert $U_1$ erreicht hat und der Komparator 2b das Flip-Flop 3 wieder setzt, die Stromquelle 5 also wieder angeschaltet wird.

Bei dem hier dargestellten erfindungsgemäßen Oszillator werden jedoch außer der Stromquelle 5 noch zwei weitere Stromquellen 6 und 7 wechselseitig ein- und ausgeschaltet, die eine weitere Kapazität $C_1$ je nach dem Zustand des Flip-Flops 3 mit einem Strom $I_1$ bzw. $I_2$ auf- bzw. entladen. Mit der dabei sich über der weiteren Kapazität $C_1$ ergebenden Spannung $U_{C1}$ wird über die Verbindung 8 die Größe des von der Stromquelle 5 erzeugten Stromes $I_0$ gesteuert. Mit der Größe von $I_0$ ändert sich auch die Aufladezeit der externen Kapazität $C_0$. Die so entstehende Regelschleife erzeugt ein dem Verhältnis von $I_1$ zu $I_2$ entsprechendes Verhältnis zwischen der Aufladezeit $T_1$ und der Entladezeit $T_2$ der externen Kapazität $C_0$, weil im eingeschwungenen Zustand für $C_1$ innerhalb einer Periode die einfließende Ladung $Q_1$ und die abfließende Ladung $Q_2$ gleich groß sein müssen.

Es gilt also: $Q_1 = I_1 \times T_1$, $Q_2 = I_2 \times T_2$
aus $Q_1 = Q_2$ folgt dann $T_1/T_2 = I_2 I_1$ oder $T_1 = T_2 (I_2/I_1)$.

Das Verhältnis der Ströme $I_1$ und $I_2$ läßt sich genau festlegen, so daß die Aufladezeit $T_1$ nur von der von $R_0$ und $C_0$ abhängigen Entladezeit $T_2$ bestimmt wird. Das Verhältnis der Ströme $I_1$ und $I_2$ ist außerdem nahezu temperaturunabhängig.

Eine eventuelle Nichtlinearität der weiteren Kapazität $C_1$ beeinflußt nicht die Oszillatorfrequenz, da die Auf- und Entladung von $C_1$ durch die Nichtlinearität gleichermaßen beeinflußt werden.

Dies bedeutet, daß die weitere Kapazität $C_1$ auf einfache Weise auch als integrierte Kapazität, z. B. als Sperrschichtkapazität ausgebildet werden kann.

Die Steilheit $I_0/U_{C1}$ der gesteuerten Stromquelle beeinflußt ebenfalls nicht die Oszillatorfrequenz, da die Ladezeiten $T_1$ und $T_2$ wie gesagt nur von $R_0$ und $C_0$ abhängen. In den Figuren 2a bis 2c ist der Spannungs- bzw. Stromverlauf nach dem Einschalten für den Fall $I_1 = I_2$ dargestellt, wenn beim Aufladen des Kondensators $C_0$ sich auch der Kondensator $C_1$ auflädt.

Fig. 2a zeigt dabei die Spannung über der externen Kapazität $C_0$. Fig. 2b die Spannung über der weiteren Kapazität $C_1$ und Fig. 2c den von der Stromquelle 5 kommenden Ladestrom $I_0$.

Sofort nach dem Einschalten ($t = 0$) lädt sich der Kondensator $C_0$ mit einem großen Strom $I_0$ auf. Da sich gleichzeitig der Kondensator $C_1$ mit dem Strom $I_1$ auflädt, steigt die Spannung $U_{C1}$ an diesem Kondensator, wodurch über die Verbindung 8 die Größe des Stroms $I_0$ abwärts geregelt wird. Erreicht die Spannung am Kondensator $C_0$ den Wert $U_2$ ($t = t_1$), werden über die Schwellwertschaltung die Ladeströme $I_0$ und $I_1$ abgeschaltet und der Entladestrom $I_2$ der Kapazität $C_1$ eingeschaltet, wodurch die Spannung $U_{C1}$ am Kondensator $C_1$ absinkt. Der Kondensator $C_0$ entlädt sich über den Widerstand $R_0$, wodurch seine Spannung absinkt, bis sie den Wert $U_1$ ($t = t_2$) erreicht und die Ladeströme $I_0$ und $I_1$ wieder eingeschaltet werden. Der Kondensator $C_1$ entlädt sich durch den Entladestrom $I_2$ im Zeitraum $t_1 - t_2$ nicht vollständig. Hierdurch steigt die Spannung $U_{C1}$ weiter an und der Strom $I_0$ wird weiter abwärts geregelt. Auf diese Weise wird der Strom $I_0$ abgeglichen, bis ($t = t_4$) der Zustand erreicht ist, bei dem der Strom $I_1$ den Kondensator $C_1$ genau so stark auflädt wie der Strom $I_2$ diesen entlädt. In diesem Zustand wird das Verhältnis der Anstiegs- und Abfallzeit $T_1/T_2$ der Sägezahnspannung nur vom Verhältnis des Entlade- und Aufladestroms ($I_2/I_1$) bestimmt.

Statt eines Auflade- bzw. Entladevorgangs des Kondensators $C_1$ beim Laden bzw. Entladen des Kondensators $C_0$ ist es auch möglich, den Kondensator $C_1$ beim Laden bzw. Entladen des Kondensators $C_0$ zu entladen bzw. zu laden. Die Steuerung der Stromquelle 5 muß dabei so ausgelegt sein, daß bei abfallender Spannung $U_{C1}$ am Kondensator $C_1$ der Ausgangsstrom $I_0$ kleiner wird.

## Patentansprüche

1. Monolithisch integrierten RC-Oszillator mit einem externen Anschluß zum Anschliessen eines zwischen diesem Anschluß und Bezugspotential liegendem externen Netzwerk aus Kapazität und Entladeschaltung, bei der mit dem Netzwerk eine periodisch ein- und ausschaltbare Ladeschaltung verbunden ist, und der eine Anschluß mit einer zwei Schaltschwellen aufweisenden Schwellwertschaltung verbunden ist, welche die Ladeschaltung ein- bzw. ausschaltet, wenn die Spannung an der Kapazität des Netzwerkes die untere, bzw. die obere Ansprechschwelle erreicht,

<u>dadurch gekennzeichnet,</u>

daß der Ladestrom der Ladeschaltung von der Spannung über einer zweiten Kapazität gesteuert wird, die während des Entladens der frequenzbestimmenden Kapazität mit einem einstellbaren Strom $I_1$ auf- bzw. entladen und während des Aufladens der Kapazität mit einem ebenfalls einstellbaren Strom $I_2$ ent- bzw. aufgeladen wird.

2. RC-Oszillator nach Anspruch 1 oder 2,
<u>dadurch gekennzeichnet,</u>
daß die zweite Kapazität mitintegriert ist.

3. RC-Oszillator nach Anspruch 1,
<u>dadurch gekennzeichnet,</u>
daß die Entladeschaltung durch einen der frequenzbstimmenden Kapazität parallel geschalteten Widerstand gebildet ist.

**Claims**

1. A monolithic integrated RC-oscillator having one external terminal for connecting an external network which comprises a capacitance and a discharge circuit and which is arranged between said terminal and reference potential, a charging circuit which can be switched on and off periodically being connected to said network, and said terminal being connected to a threshold circuit which has two switching thresholds and which causes the charging circuit to be switched on and switched off when the voltage across the capacitance of the network reaches the lower and the upper switching threshold respectively, <u>characterized in that</u> the charging current of the charging circuit is controlled by the voltage across a second capacitance which is charged and discharged respectively with a current $I_1$ when the frequency-determining capacitance is discharged and which is discharged and charged respectively with a current $I_2$ when the said frequency-determing capacitance is charged.

2. An RC-oscillator as claimed in Claim 1, <u>characterized in that</u> the second capacitance is also integrated.

3. An RC-oscillator as claimed in Claim 1, <u>characterized in that</u> the discharging circuit comprises a resistor which is arranged in parallel with the frequency-determining capacitance.

**Revendications**

1. Oscillateur RC intégré monolithique comportant une connexion externe pour connecter un réseau externe situé entre cette connexion et le potentiel de référence et constitué par un condensateur et un circuit de décharge, dans lequel un circuit de charge pouvant être enclenché et déclenché périodiquement est connecté au réseau et une connexion est reliée à un circuit à seuil présentant deux seuils de commutation et assurant l'enclenchement respectivement le déclenchement du circuit de charge lorsque la tension au condensateur du réseau atteint le seuil de réponse inférieur respectivement supérieur, caractérisé en ce que le courant de charge du circuit de charge est commandé par la tension aux extrémités d'un deuxième condensateur qui est chargé respectivement déchargé pendant la décharge du condensateur déterminant la fréquence d'un courant à régler $I_1$ et qui est déchargé respectivement chargé pendant la charge du condensateur d'un courant également à régler $I_2$.

2. Oscillateur RC selon la revendication 1 ou 2, caractérisé en ce que le deuxième condensateur est également intégré.

3. Oscillateur RC selon la revendication 1, caractérisé en ce que le circuit de décharge est formé par une résistance montée en parallèle avec le condensateur déterminant la fréquence.

Fig. 1

Fig. 2a

Fig. 2b

Fig. 2c